# EUROPEAN PATENT SPECIFICATION

(11) **EP 2 804 198 B1**
(45) Date of publication and mention of the grant of the patent: **16.08.2017**
(21) Application number: 14168014.0
(22) Date of filing: 13.05.2014
(51) Int. Cl.: H01H 83/04, H01H 83/14, H02H 3/26, H01R 13/713, H01H 89/06, H01H 71/12, H01H 1/00

(54) **Arrangement and method for detecting the jamming of an electromechanical switch**
Vorrichtung und Verfahren zur Erkennung einer Blockierung eines elektromechanisches Schaltgerätes
Agencement et procédé pour détecter un blocage d'un interrupteur électromécanique

(30) Priority: 14.05.2013 FI 20135509
(43) Date of publication of application: 19.11.2014
(73) Proprietor: Ensto Finland Oy, 06100 Porvoo (FI)
(72) Inventor: Mäittälä, Atte, 07510 Vakkola (FI)
(74) Representative: Papula Oy

(56) References cited:
- DE-B1- 2 920 188
- US-A- 5 243 291
- US-A1- 2004 212 935

## Description

### TECHNICAL FIELD

The invention relates to current supply devices controlled by electromechanical switches and to the detection of jamming of the mechanical terminals therein or similar fault states. One special embodiment of such sockets encompasses for example the sockets of charging points and charging stations for electric vehicles. More specifically, the invention relates to the arrangement and the method according to the preamble of the independent claims.

### TECHNICAL BACKGROUND

The primary application area of the invention thus encompasses the current supply devices of charging points and charging stations for electric vehicles, such as sockets, plugs and plug connectors. Since these devices may develop a safety risk for the user, the reliability and safety of the devices is extremely important. Thus, for example in approvals for new systems, a charging point contactor terminal jamming test is required. This test has a purpose and effect that greatly improve the user safety, because the test aims to ensure that a free charging plug is not energized due to a jammed contactor. One approval requires that the test must be carried out at some stage before charging and, in the case of a jammed contactor, the circuit must be opened and the fault state indicated by error lights.

In the prior art solutions, one problem in carrying out the contactor jamming test has been the high cost and low performance. In the prior solutions, the jamming test has been carried out with a mechanical auxiliary relay connected to the contactor or by voltage measurement by which the jammed contactor is detected. In some prior solutions, another contactor has been used to open the circuit. In these solutions, the jammed contactor is criticized separately at a specific time and, if required, the circuit is opened. The above-mentioned prior art solutions are expensive and, in performance, from the user safety point of view, are mediocre at best. For example, when the two contactors are identical, it is possible that both fail at the same time, for instance due to an external condition.

US5243291 discloses a circuit for detecting the deposition of an electromagnetic contactor which opens and closes a drive circuit connecting a power source to a load. A load current of the drive circuit and an operating current for operating the electromagnetic contactor are detected and applied to a detection circuit. The thus detected load current and operating current are used to determine the deposition of the electromagnetic contactor. Further, in the event of a detected malfunction in the electromagnetic contactors, a breaker of the drive circuit is automatically opened.

### SUMMARY OF THE INVENTION

The objective of the present invention is to provide a new arrangement and method for detecting the jamming of an electromechanical switch in a current supply device controlled by the electromechanical switch, which arrangement and method provide, as compared to the state of the art solutions, an improvement particularly in terms of user safety. Examples of the electromechanical switches include relays and contactors. In the arrangement according to the invention, the current supply device controlled by the electromechanical switch is connected to a circuit, wherein electrical power is supplied to the current supply device through a residual-current device and the electromechanical switch provided after the residual-current device in the circuit. Furthermore, the circuit is provided with a controller, wherein when the electromechanical switch is jammed, i.e. the terminals of the switch are latched at an unwanted point of time, the residual-current device is connected so as to trip and the circuit to open by driving the current past the residual-current device. According to the invention, a separately connecting resistor is arranged, coupled between two phases, to drive the current past the residual-current device. The resistor is for example a disconnecting and connecting resistor contained by the circuit controller and connected in the circuit between the phase before the residual-current device and the 0-wire after the residual-current device so that a current difference is formed between the supply and exit currents of the residual current device when the resistor is energized. In one embodiment, the resistor is arranged to disconnect when the tested circuit is controlled so as to be energized. In one embodiment, the resistor is arranged to disconnect after a predetermined time from the connection of the resistor, in which case the jamming test is conducted for a time of a defined duration.

In one embodiment, the resistor is arranged to connect when the tested circuit is controlled so as to be de-energized. The connection of the resistor may be provided with a delay from the tested circuit control. The delay may be provided programmatically in the circuit of the current supply device, by a mechanical switch arranged in the current supply device or the like. In one embodiment, the circuit is provided with a push button, the pushing of which connects the current past the residual-current device, causing the tripping of the residual-current device.

Further, the invention relates to a method for detecting the jamming of an electromechanical switch, wherein, when the electromechanical switch is jammed, i.e. the terminals of the switch are latched at an unwanted point of time, the residual-current device is tripped and the circuit opened by driving the current past the residual-current device. According to the invention, the current is driven past the residual-current device by a separately connecting resistor, coupled between two phases. In one embodiment, the resistor is a disconnecting and connecting resistor contained by the circuit controller and connected to the circuit between the phase before the residual-current device and the 0-wire after the residual-current device so that the resistor provides a current difference between the supply and exit currents of the residual-current device when the resistor is energized. In one embodiment, the resistor is disconnected when the tested circuit is controlled so as to be energized. In one embodiment, the resistor is connected when the tested circuit is controlled so as to be de-energized. In one embodiment, the resistor is connected with a delay from the tested circuit control. In one embodiment, the delay is provided programmatically in the circuit of the current supply device. In one embodiment, the delay is provided by a mechanical switch arranged in the current supply device or the like.

The invention provides significant advantages over the prior art. One of the most significant advantages over the state of the art is that the user safety is improved more than in the prior art solutions without the cost of the functionality that enhances the safety affecting the manufacturing costs of the product. Due to the invention, the electromechanical switch jamming test may be an on-going one, if required, when a current supply device such as a plug is not connected. This is an essential advantage in particular in connection with charging stations for electric cars. Detection of the jamming of an electromechanical switch and the resulting tripping of a residual-current device are provided for example by a resistor connected to the circuit and causing the residual-current device to trip naturally. Thus, detection of the jamming of the electromechanical switch and opening of the circuit are independent of the control logic and the reaction is very prompt. Furthermore, it is extremely noteworthy that the invention can be carried out with the components available at the charging point and the manufacturing cost is not changed. Only the circuit diagram and the control logic of the arrangement are changed. No additional components are necessary.

Other advantages and characteristics of the invention are disclosed in the following detailed description of the invention, in which the invention will be described with reference to the figures of the accompanying drawing, to the details of which the invention is not exclusively limited.

### BRIEF DESCRIPTION OF THE FIGURES

Fig. 1 is a circuit diagram of one charging point circuit connection.
Fig. 2 is a circuit diagram of another charging point circuit connection.

### DETAILED DESCRIPTION OF THE PREFERRED EMBODIMENTS

In the figures of the drawing, corresponding components are referenced alike and, in order to simplify the diagrams, they only show the components that are relevant for the invention.

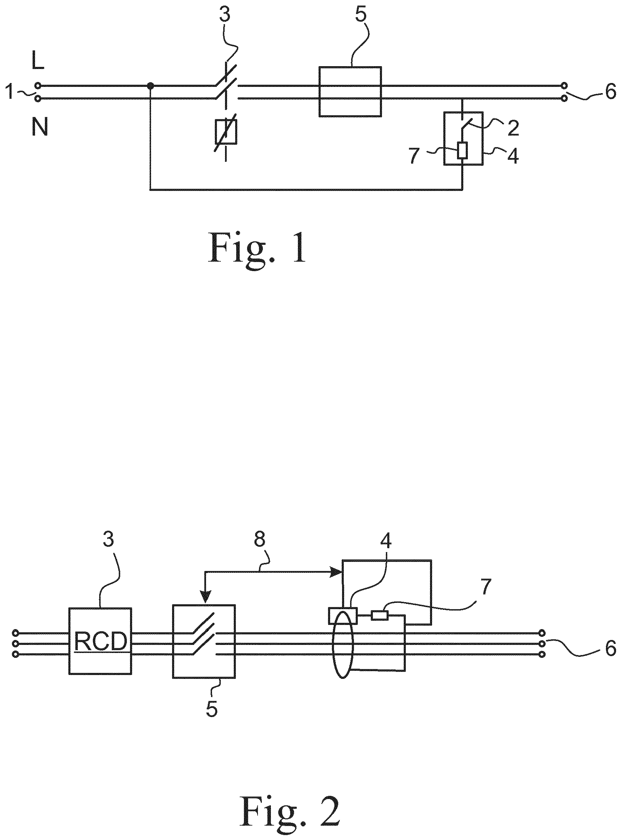

In the charging circuits according to Fig. 1 and 2, the components are so positioned that, after a power supply 1, a residual-current device 3 is first provided, followed by a contactor 5 and finally by a socket 6. In the figures, a circuit controller is referenced as 4 and a resistor contained by the controller as 7. One example of the circuit controller 4 is the EVI controller provided by Ensto or another applicable microcontroller-based controller.

When charging is not on in the charging circuit, the resistor 7 is kept connected between the phase L1 before the residual-current device 3 and the 0-wire N after the residual-current device 3, the resistor 7 then providing, when energized, a current difference over the residual-current device 3. The resistor 7 is disconnected by a switch 2 when a charging cable connected to the socket 6 is detected. In the case where the contactor 5 is jammed, i.e. the terminals of the contactor 5 are latched at an unwanted point of time, the residual-current device 3 is tripped by driving the current past the residual-current device 3 with the separately connected resistor 7. The resistor thus simulates a possible problem situation, i.e. a person touching the charging socket energized due to the jammed contactor 5. If the contactor 5 is jammed, the resistor 7 immediately provides a current difference, as a result of which the residual-current device 3 trips, opens the circuit, and the indicator light, if provided, of the charging point signals an error condition.

Since the jamming test of a contactor 5 is always conducted in the arrangement according to the invention when the charging cable is disconnected from a socket 6, there must be a small delay in the connection of the resistor 7 so that the arrangement of the invention would function as intended. The delay ensures that the residual-current device does not trip unnecessarily. This delay may be provided in several alternative ways. This delay may be arranged e.g. programmatically, the socket 6 may be provided with a mechanical, e.g. spring-loaded, lever or may have a switch or a breaker provided with a shape-memory alloy. From the socket 6, information about the connection of the charging cable is transmitted to the circuit controller 2 either through a data communication line, as an electronic signal or mechanically.

Fig. 2 shows another charging point circuit connection, wherein the charging point is provided at a three-phase voltage. In addition to a contactor 5 connected after a residual-current device 3, the system includes a connection coupling a resistor 7 between two phases. The connection may include one or several resistors 7.

In one embodiment, the resistor 7 is arranged to disconnect under the control of a controller 4 when the jamming test has been conducted. The resistor 7 is connected for a predetermined time. The time is defined in the circuit controller 4 so that, in the course of that time, sufficient certainty of jamming of the terminals of the contactor 5 is reached.

In one embodiment, the resistor 7 is arranged to remain connected until the contactor 5 is closed and to disconnect at the moment or a moment before the closing of the contactor. From the contactor 5, for example a mechanical link 8 to a switch 2 that isolates the resistor is provided. This prevents the connected resistor 7 from providing the tripping of the residual-current device 3 when the terminals of the contactor 5 are intentionally connected.

It is to be understood that the exemplified embodiments are provided by way of example, and many modifications are possible in a specific apparatus used to carry out the exemplified embodiments, which is obvious for a person skilled in the hardware and/or software art. For example, the functionality of one or more components of the exemplified embodiments may be implemented with one or more apparatuses and/or software devices.

The exemplified embodiments may store information related to different processes described herein. This information may be stored on one or more memories, such as hard disks, optical disks, magnetooptical disks, RAM or the like. One or more databases may store information which is used to carry out the exemplified embodiments of the present invention. The databases may be organized using data structures (for example records, tables, lines, fields, graphs, trees, lists and the like) included in one or more memories or storage devices listed herein. The processes described in connection with the exemplified embodiments may include suitable data structures for storing the data gathered and/or formed by the processes of the devices or subsystems of the exemplified embodiments in one or more databases.

All or some of the exemplified embodiments may be suitably carried out using one or more general-purpose processors, microprocessors, digital signal processors, microcontrollers and the like, programmed according to the teachings of the exemplified embodiments of the present invention, as appreciated by a person skilled in the computer and software art. Regular programmers may readily produce appropriate software on the basis of the teachings of the exemplified embodiments, as is obvious for a person skilled in the software art. Furthermore, the exemplified embodiments may be carried out by producing ASIC circuits or by combining regular component circuits into an appropriate network, as appreciated by a person skilled in the electronic art. Thus, the exemplified embodiments are not limited to any specific combination of hardware and/or software.

Stored on any combination of computer-readable media, the exemplified embodiments of the present invention may contain software for controlling the components of the exemplified embodiments, for running the components of the exemplified embodiments, for enabling the interaction of the components of the exemplified embodiments with a human user, and the like. Such software may but is not limited to contain device drivers, firmware, operating systems, development tools, applications and the like. Such computer-readable media may further comprise a computer program product of an embodiment of the present invention for performing all the processing or part of the processing (if the processing is distributed) to be performed for carrying out the invention.

The invention has been described above by way of example with reference to the figures of the accompanying drawing. However, the invention is not limited merely to the examples shown in the figures; instead, the different embodiments of the invention may vary within the scope of the inventive idea defined in the accompanying claims.

## Claims

1. An arrangement for detecting the jamming of an electromechanical switch in a current supply device controlled by the electromechanical switch and connected to a circuit, wherein electrical power is supplied to the current supply device (6) through a residual-current device (3) and the electromechanical switch (5) provided after the residual-current device in the circuit, and the circuit being provided with a controller (4), wherein when the electromechanical switch (5) is jammed, i.e. the terminals of the switch are latched at an unwanted point of time, the residual-current device (3) is connected so as to trip and the circuit to open by driving the current past the residual-current device (3), **characterized in that** a separately connecting resistor (7) is arranged, coupled between two phases, to drive the current past the residual-current device (3).

2. The arrangement according to claim 1, **characterized in that** the resistor (7) is a disconnecting and connecting resistor (7) contained by the circuit controller (4) and connected in the circuit between the phase (L1) before the residual-current device (3) and the 0-wire (N) after the residual-current device (3) so that a current difference is formed between the supply and exit currents of the residual-current device (3) when the resistor (7) is energized.

3. The arrangement according to claim 1 or 2, **characterized in that** the resistor (7) is arranged to disconnect when the tested circuit is controlled so as to be energized.

4. The arrangement according to claim 1 or 2, **characterized in that** the resistor (7) is arranged to disconnect after a predetermined time from the connection of the resistor.

5. The arrangement according to claim 1 or 2, **characterized in that** the resistor (7) is arranged to connect when the tested circuit is controlled so as to be de-energized.

6. The arrangement according to claim 4, **characterized in that** the connection of the resistor (7) is provided with a delay from the tested circuit control (6).

7. The arrangement according to claim 5, **characterized in that** the delay is provided programmatically in the circuit of the current supply device (6).

8. The arrangement according to claim 5, **characterized in that** the delay is provided with a mechanical switch arranged in the current supply device (6) or the like.

9. The arrangement according to claim 1 or 2, **characterized in that** the circuit is provided with a push button, the pushing of which connects the current past the residual-current device (3), providing the tripping of the residual-current device (3).

10. A method for detecting the jamming of an electromechanical switch in a current supply device controlled by the electromechanical switch and connected to a circuit, wherein electrical power is supplied to the current supply device (6) through a residual-current device (3) and a contactor or a relay (5) provided after the residual-current device in the circuit, and the circuit being provided with a controller (4), wherein when the electromechanical switch (5) is jammed, i.e. the terminals of the switch are latched at an unwanted point of time, the residual-current device (3) is tripped and the circuit opened by driving the current past the residual-current device (3), **characterized in that** the current is driven past the residual-current device (3) by a separately connecting resistor (7) coupled between two phases.

11. The method according to claim 10, **characterized in that** the resistor (7) is a disconnecting and connecting resistor (7) contained by the circuit controller (4) and connected to the circuit between the phase (L1) before the residual-current device (3) and the 0-wire (N) after the residual-current device (3) so that the resistor (7) provides a current difference between the supply and exit currents of the residual-current device (3) when the resistor is energized.

12. The method according to claim 10 or 11, **characterized in that** the resistor (7) is disconnected when the tested circuit is controlled so as to be energized.

13. The method according to claim 10 or 11, **characterized in that** the resistor (7) is connected when the tested circuit is controlled so as to be de-energized.

14. The method according to claim 13, **characterized in that** the resistor (7) is connected with a delay from the tested circuit control (6).

15. The method according to claim 14, **characterized in that** the delay is provided programmatically in the circuit of the current supply device (6).

16. The method according to claim 14, **characterized in that** the delay is provided with a mechanical switch arranged in the current supply device (6) or the like.

## Patentansprüche

1. Anordnung zum Erkennen des Blockierens eines elektromechanischen Schaltgerätes in einem durch das elektromechanische Schaltgerät gesteuerten und an einen Schaltkreis angeschlossenen Stromversorgungsgerät, wobei elektrische Leistung an das Stromversorgungsgerät (6) über einen Fehlerstromschutzschalter (3) und das dem Fehlerstromschutzschalter in dem Schaltkreis nachgeschalteten elektromechanische Schaltgerät (5) geliefert wird, und wobei der Schaltkreis mit einer Steuerung (4) ausgestattet ist, wobei, wenn das elektromechanische Schaltgerät (5) blockiert ist, d.h. die Anschlussklemmen des Schaltgerätes zu einem unerwünschten Zeitpunkt verklinkt sind, der Fehlerstromschutzschalter (3) verbunden wird, sodass dieser auslöst und der Schaltkreis sich durch Treiben des Stromes durch den Fehlerstromschutzschalter (3) öffnet, **dadurch gekennzeichnet, dass** ein separat verbindender Widerstand (7) zwischen zwei Leitern gekoppelt angeordnet ist, um den Strom durch den Fehlerstromschutzschalter (3) zu treiben.

2. Anordnung nach Anspruch 1, **dadurch gekennzeichnet, dass** der Widerstand (7) ein in der Schaltsteuerung (4) enthaltener, verbindender und trennender Widerstand (7) ist und in dem Schaltkreis zwischen der Phase (L1) vor dem Fehlerstromschutzschalter (3) und dem Nullleiter (N) nach dem Fehlerstromschutzschalter (3) angeschlossen ist, sodass eine Stromdifferenz zwischen den Versorgungs- und den Ausgangsströmen des Fehlerstromschutzschalters (3) entsteht, wenn der Widerstand (7) mit Strom versorgt wird.

3. Anordnung nach Anspruch 1 oder 2, **dadurch gekennzeichnet, dass** der Widerstand (7) so angeordnet ist sich zu trennen, wenn der geprüfte Schaltkreis so gesteuert wird, dass er mit Strom versorgt wird.

4. Anordnung nach Anspruch 1 oder 2, **dadurch gekennzeichnet, dass** der Widerstand (7) so angeordnet ist sich nach einer vorbestimmten Zeit von der Verbindung des Widerstandes zu trennen.

5. Anordnung nach Anspruch 1 oder 2, **dadurch gekennzeichnet, dass** der Widerstand (7) so angeordnet ist sich zu verbinden, wenn der geprüfte Schaltkreis so gesteuert wird, dass er nicht mit Strom versorgt wird.

6. Anordnung nach Anspruch 4, **dadurch gekennzeichnet, dass** die Verbindung des Widerstandes (7) mit einer Verzögerung durch die geprüfte Schaltkreissteuerung (6) bereitgestellt wird.

7. Anordnung nach Anspruch 5, **dadurch gekennzeichnet, dass** die Verzögerung programmatisch in dem Schaltkreis des Stromversorgungsgerätes (6) bereitgestellt wird.

8. Anordnung nach Anspruch 5, **dadurch gekennzeichnet, dass** die Verzögerung mit einem in dem Stromversorgungsgerät (6) angeordneten mechanischen Schaltgerät oder dergleichen bereitgestellt wird.

9. Anordnung nach Anspruch 1 oder 2, **dadurch gekennzeichnet, dass** der Schaltkreis mit einem Druckknopf versehen ist, wobei das Drücken desselben den Strom durch den Fehlerstromschutzschalter (3) verbindet, wodurch das Auslösen des Fehlerstromschutzschalters (3) bereitgestellt wird.

10. Verfahren zum Erkennen eines Blockierens eines elektromechanischen Schaltgerätes in einem durch das elektromechanische Schaltgerät gesteuerten und an einen Schaltkreis angeschlossenem Stromversorgungsgerät, wobei elektrische Leistung an das Stromversorgungsgerät (6) über einen Fehlerstromschutzschalter (3) und einem dem Fehlerstromschutzschalter in dem Schaltkreis nachgeschalteten Relais oder Schaltschütz (5) geliefert wird, und wobei der Schaltkreis mit einer Steuerung (4) ausgestattet ist, wobei, wenn das elektromechanische Schaltgerät (5) blockiert ist, d.h. die Anschlussklemmen des Schaltgerätes zu einem unerwünschten Zeitpunkt verklinkt sind, der Fehlerstromschutzschalter (3) ausgelöst ist und der Schaltkreis durch Treiben des Stromes durch den Fehlerstromschutzschalter (3) geöffnet ist, **dadurch gekennzeichnet, dass** der Strom durch den Fehlerstromschutzschalter (3) über einen separat verbindenden, zwischen zwei Leitern gekoppelten Widerstand (7) getrieben wird.

11. Verfahren nach Anspruch 10, **dadurch gekennzeichnet, dass** der Widerstand (7) ein in der Schaltsteuerung (4) enthaltener, verbindender und trennender Widerstand (7) ist und mit dem Schaltkreis zwischen der Phase (L1) vor dem Fehlerstromschutzschalter (3) und dem Nullleiter (N) nach dem Fehlerstromschutzschalter (3) verbunden ist, sodass der Widerstand (7) eine Stromdifferenz zwischen den Versorgungs- und den Ausgangsströmen des Fehlerstromschutzschalters (3) bereitstellt, wenn der Widerstand mit Strom versorgt wird.

12. Verfahren nach Anspruch 10 oder 11, **dadurch gekennzeichnet, dass** der Widerstand (7) sich trennt, wenn der geprüfte Schaltkreis so gesteuert wird, dass er mit Strom versorgt wird.

13. Verfahren nach Anspruch 10 oder 11, **dadurch gekennzeichnet, dass** der Widerstand (7) sich verbindet, wenn der geprüfte Schaltkreis so gesteuert wird, dass er nicht mit Strom versorgt wird.

14. Verfahren nach Anspruch 13, **dadurch gekennzeichnet, dass** der Widerstand (7) mit einer Verzögerung durch die geprüfte Schaltkreissteuerung (6) verbunden wird.

15. Verfahren nach Anspruch 14, **dadurch gekennzeichnet, dass** die Verzögerung programmatisch in dem Schaltkreis des Stromversorgungsgerätes (6) bereitgestellt wird.

16. Verfahren nach Anspruch 14, **dadurch gekennzeichnet, dass** die Verzögerung mit einem in dem Stromversorgungsgerät (6) angeordneten mechanischen Schaltgerät oder dergleichen bereitgestellt wird.

## Revendications

1. Agencement pour détecter le blocage d'un interrupteur électromécanique dans un dispositif d'alimentation en courant commandé par l'interrupteur électromécanique et connecté à un circuit, dans lequel une énergie électrique est délivrée au dispositif d'alimentation en courant (6) à travers un dispositif de courant résiduel (3) et l'interrupteur électromécanique (5) disposé après le dispositif de courant résiduel dans le circuit, et le circuit étant muni d'un contrôleur (4), dans lequel, quand l'interrupteur électromécanique (5) est bloqué, c'est-à-dire que les bornes de l'interrupteur sont verrouillées en un point temporel indésirable, le dispositif de courant résiduel (3) est connecté de manière à se déclencher et le circuit à s'ouvrir en conduisant le courant au-delà du dispositif de courant résiduel (3), **caractérisé en ce qu'**une résistance à connexion séparée (7) est agencée, couplée entre deux phases, pour conduire le courant au-delà du dispositif de courant résiduel (3).

2. Agencement selon la revendication 1, **caractérisé en ce que** la résistance (7) est une résistance de déconnexion et connexion (7) contenue par le contrôleur de circuit (4) et connectée dans le circuit entre la phase (L1) avant le dispositif de courant résiduel (3) et le fil 0 (N) après le dispositif de courant résiduel (3) de manière qu'une différence de courant soit formée entre les courants d'alimentation et de sortie du dispositif de courant résiduel (3) quand la résistance (7) est alimentée.

3. Agencement selon la revendication 1 ou 2, **caractérisé en ce que** la résistance (7) est agencée pour se déconnecter quand le circuit testé est commandé de manière à être alimenté.

4. Agencement selon la revendication 1 ou 2, **caractérisé en ce que** la résistance (7) est agencée pour se déconnecter après un temps prédéterminé à partir de la connexion de la résistance.

5. Agencement selon la revendication 1 ou 2, **caractérisé en ce que** la résistance (7) est agencée pour se connecter quand le circuit testé est commandé de manière à ne pas être alimenté.

6. Agencement selon la revendication 4, **caractérisé en ce que** la connexion de la résistance (7) est prévue avec un retard par rapport à la commande de circuit testé (6).

7. Agencement selon la revendication 5, **caractérisé en ce que** le retard est fourni par programmation dans le circuit du dispositif d'alimentation en courant (6).

8. Agencement selon la revendication 5, **caractérisé en ce que** le retard est fourni avec un commutateur mécanique agencé dans le dispositif d'alimentation en courant (6) ou similaire.

9. Agencement selon la revendication 1 ou 2, **caractérisé en ce que** le circuit est muni d'un bouton poussoir, dont l'actionnement connecte le courant au-delà du dispositif de courant résiduel (3), en fournissant le déclenchement du dispositif de courant résiduel (3).

10. Procédé pour détecter le blocage d'un interrupteur électromécanique dans un dispositif d'alimentation en courant commandé par l'interrupteur électromécanique et connecté à un circuit, dans lequel une énergie électrique est délivrée au dispositif d'alimentation en courant (6) à travers un dispositif de courant résiduel (3) et un contacteur ou un relais (5) disposé après le dispositif de courant résiduel dans le circuit, et le circuit étant muni d'un contrôleur (4), dans lequel, quand l'interrupteur électromécanique (5) est bloqué, c'est-à-dire que les bornes de l'interrupteur sont verrouillées en un point temporel indésirable, le dispositif de courant résiduel (3) est déclenché et le circuit est ouvert en conduisant le courant au-delà du dispositif de courant résiduel (3), **caractérisé en ce que** le courant est conduit au-delà du dispositif de courant résiduel (3) par une résistance à connexion séparée (7), couplée entre deux phases.

11. Procédé selon la revendication 10, **caractérisé en ce que** la résistance (7) est une résistance de déconnexion et connexion (7) contenue par le contrôleur de circuit (4) et connectée dans le circuit entre la phase (L1) avant le dispositif de courant résiduel (3) et le fil 0 (N) après le dispositif de courant résiduel (3) de manière que la résistance (7) fournisse une différence de courant entre les courants d'alimentation et de sortie du dispositif de courant résiduel (3) quand la résistance est alimentée.

12. Procédé selon la revendication 10 ou 11, **caractérisé en ce que** la résistance (7) est déconnectée quand le circuit testé est commandé de manière à être alimenté.

13. Procédé selon la revendication 10 ou 11, **caractérisé en ce que** la résistance (7) est connectée quand le circuit testé est commandé de manière à ne pas être alimenté.

14. Procédé selon la revendication 13, **caractérisé en ce que** la résistance (7) est connectée avec un retard par rapport à la commande de circuit testé (6).

15. Procédé selon la revendication 14, **caractérisé en ce que** le retard est fourni par programmation dans le circuit du dispositif d'alimentation en courant (6).

16. Procédé selon la revendication 14, **caractérisé en ce que** le retard est fourni avec un commutateur mécanique agencé dans le dispositif d'alimentation en courant (6) ou similaire.
